(19) Europäisches Patentamt
European Patent Office
Office européen des brevets

(11) **EP 1 065 510 B1**

(12) **EUROPEAN PATENT SPECIFICATION**

(45) Date of publication and mention
of the grant of the patent:
**12.08.2009 Bulletin 2009/33**

(51) Int Cl.:
**G01R 31/08** *(2006.01)*

(21) Application number: **00660114.0**

(22) Date of filing: **20.06.2000**

(54) **Location of restriking and transient earth faults**

Lokalisierung von intermittierenden und transienten Erdschlüssen

Emplacement de rallumage et de défauts de terre transitoires

(84) Designated Contracting States:
**DE FR GB**

(30) Priority: **28.06.1999 FI 991465**

(43) Date of publication of application:
**03.01.2001 Bulletin 2001/01**

(73) Proprietor: **ABB Oy**
**00380 Helsinki (FI)**

(72) Inventor: **Kuisti, Harri**
**02720 Espoo (FI)**

(74) Representative: **Peltonen, Antti Sakari et al**
**Kolster Oy Ab**
**Iso Roobertinkatu 23**
**P.O. Box 148**
**00121 Helsinki (FI)**

(56) References cited:
**DE-A- 3 344 208          US-A- 5 839 093**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

BACKGROUND OF THE INVENTION

The invention relates to earth fault protection of an electric network and especially to locating intermittent and transient earth faults in an electric network.

Earth faults of many types occur in an electric distribution network. Some of the faults create a connection between a phase conductor and earth that remains relatively stable in its fault resistance. In underground systems, such faults are usually permanent and require isolating the faulty cable section from the network. Overhead lines, for their part, have a lot of electric arc faults which can be eliminated by switching the wire dead for a while.

A second type of earth fault is an intermittent earth fault in which earth contact occurs and ends in turn causing a long-term disturbance in the network unless the faulty line section is isolated from the network. Usually an intermittent earth fault is related to a damaged insulator. One example is a hole in the underground cable insulation, in which consecutive electric breakdowns occur. Between the electric breakdowns, the earth contact ends. Intermittent earth faults occur especially in networks earthed with a Petersen coil, in which the probability that the earth faults self-extinguish is high. Intermittent earth faults as well as transient faults may, however, also occur in networks whose star point is left unearthed or is earthed with a high resistance.

Intermittent faults occur where the insulation of cables and cable terminal boxes or cable joints is damaged due to mechanical load, material defects or age, for instance. An intermittent earth fault may seemingly disappear, if the line is switched dead for a while. The reason for this is the disappearance of the ionisation caused by electric breakdowns when the line is dead.

In an overhead line network, plenty of transient earth faults that require no relay operations also occur. The proportion of these faults is especially high in networks earthed with a Petersen coil, but they also occur in networks whose star point is left unearthed or has been earthed with a high resistance. There are different types of transient faults. Some of them resemble permanent earth faults, and the same known methods can be used to locate them. In this context, the term 'transient earth fault' refers to an earth fault in which earth contact is so short-timed that it extinguishes immediately after the voltage of the faulty phase has diminished enough and the charge of the direct capacity to earth of the faulty phase has had time to discharge. This produces similar short-timed current pulses as in intermittent earth faults.

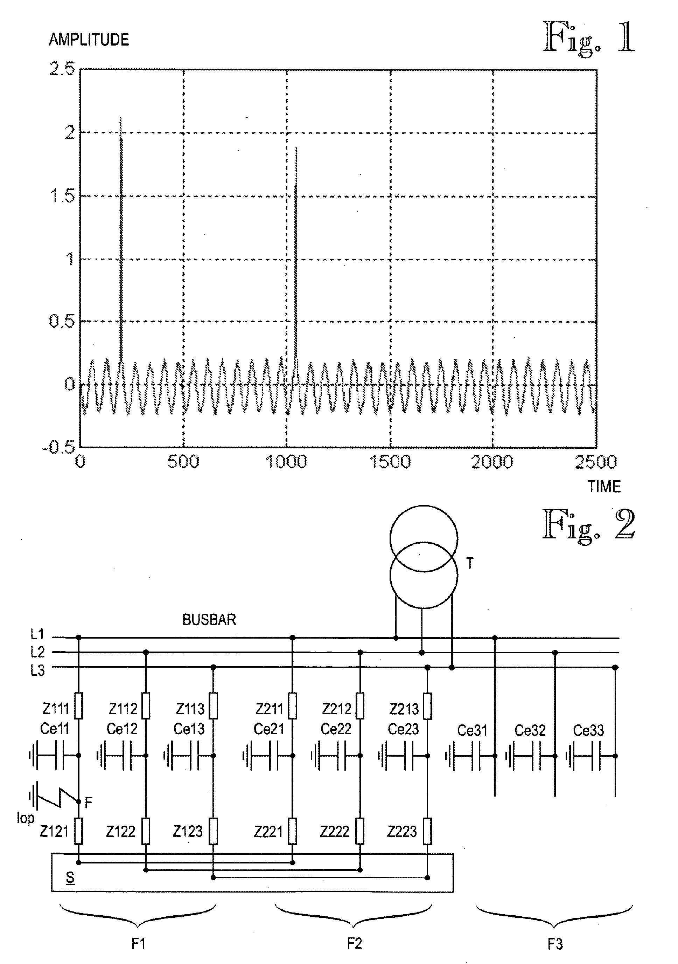

Figure 1 shows by way of example the current of a faulty phase during an intermittent or transient fault. Similar current pulses also occur in the sum of phase currents, also called zero current. The ratio of the current pulse amplitude in zero current to the fundamental component amplitude is, however, significantly higher than in the current of a faulty phase.

To be able to eliminate the fault after relay operation, it must first be located. Conventionally, only permanent earth faults have been located. There are various methods for this. In a network earthed with a low resistance, earth faults are usually located in the same manner as short-circuits by measuring the line impedance until the faulty point during the fault or by calculating the distance to the fault by means of the size of the fault current stored during the fault and a network data system. DE 3344208 discloses a method for measuring earth fault currents in earthed systems. US 5839093 discloses a system for locating faults and estimating fault resistance in distribution networks. In networks whose star point has been left unearthed or has been earthed with a high impedance, such as with a Petersen coil or resistance, locating permanent earth faults can be done using known methods which are based on the current and voltage transients occurring at the time an earth fault is created or on changes in the fundamental component currents and voltages when a faulty line is connected in a ring with another line.

An intermittent earth fault causes a relay operation and then an interruption in the electricity supply. Even though the intermittent fault may seem to disappear by switching the line dead, its original cause, i.e. insulation damage, does not disappear, but will show up later as a new fault, relay operation and an interruption in supply. Thus, it would be advantageous to be able to also locate at least roughly an intermittent earth fault so as to be able to rearrange the network configuration in such a manner that the line with the faulty line section has as low a load as possible. Then, when new relay operation occurs due to the intermittent fault, and finally a permanent fault occurs, as few customers as possible suffer from the resulting interruption in supply.

Locating transient faults is not necessary, because no relay operation or fault elimination is required. Locating transient faults is, however, advantageous, since a transient fault may be associated with a developing fault which later becomes a permanent one. In such a situation, the original cause of the fault can be eliminated even before a permanent fault is created, thus minimising the dangers, drawbacks and damages caused by the fault. Locating developing faults is thus preventive condition monitoring of an electric network.

Because there are no transients suitable for transient fault location associated with the current peaks and phase voltages caused by an intermittent or transient earth fault, and the fundamental component quantities do not in this case contain information on the location of the fault, it is not possible to locate these faults by methods used in locating permanent faults.

BRIEF DESCRIPTION OF THE INVENTION

It is thus an object of the invention to develop a method and a system implementing the method so as to solve the above-mentioned problems. The object of the invention is achieved by a method and system characterized in what is stated in the independent claims 1 and 7. Preferred embodiments of the invention are set forth in the dependent claims.
The invention is based on measuring the amplitudes of the current pulses caused by the fault at both ends of a ring line. The operation of the invention thus requires either using the lines in a ring or connecting the faulty line in a ring with an intact line at least during measurements. The distance of the faulty point can be determined after the measurements by means of the measured amplitude values and known network impedance values.
The method and system of the invention provide the advantage that the invention makes it possible to locate intermittent and transient earth faults.

BRIEF DESCRIPTION OF THE FIGURES

In the following, the invention will be described in greater detail by means of preferred embodiments with reference to the attached drawings in which

Figure 1 shows an example of the current of a faulty phase related to an intermittent or transient earth fault, and
Figure 2 shows a diagram of the structure of an electric distribution network according to an embodiment of the invention.

DETAILED DESCRIPTION OF THE INVENTION

In the following, the operation of the invention is described in a medium-voltage electric distribution network. It should, however, be noted that this does not in any way restrict the application of the invention to other types of electric networks. The configuration and voltage level of the network, for instance, may change.
Figure 2 shows a diagram of a typical electric distribution network. The figure shows only the components necessary for understanding the invention. The network is fed through a transformer T. The network also comprises a busbar and three line outlets F1, F2 and F3. It should be noted that there may be any number of line outlets in the network. There may also be several feeding transformers. Further, the invention can be utilised with a transformerless switching station. The network has three phases L1, L2 and L3. The direct capacities to earth of the phases of the line outlet F1 are $Ce11$, $Ce12$ and $Ce13$. Correspondingly, the direct capacities to earth of the phases of the line outlet F2 are $Ce21$, $Ce22$ and $Ce23$, and of the line outlet F3 $Ce31$, $Ce32$ and $Ce33$. In addition, the longitudinal impedances $Z111$ to $Z223$ of the phases of the line outlets F1 and F2 are shown. The figure also shows an earth fault in point F where the phase L1 of the line outlet F1 is in earth contact. Further, the figure shows a switching apparatus S, for instance a remotely controlled disconnector substation, by means of which the line outlets F1 and F2 can be connected in a loop in such a manner that the ends of the loop are the ends of the line outlets coming into the busbar.
In most countries, a distribution network is not normally used in a ring. Applying the method thus requires the connection of the faulty line F1 in a ring for some time after the fault has been created. The ring can also be formed of one line F1, F2 or F3, which is, however, radial to the outside, i.e. which is fed at one point only. When the faulty line F1 is temporarily connected in a ring with an intact outlet, for instance F2, after the fault F has occurred, the system must include means to detect which line is faulty and means to transmit this information to an apparatus (not shown in the figure) comparing the measurements of the various lines. There must also be an apparatus (not shown) which makes a decision on which intact line is connected in a ring with the faulty one, and informs the decision to the apparatus comparing the measurements of the various lines. The decision in question may as well be already made by an operator on the apparatus S which performs the ring connection. All the necessary communications connections and other required apparatuses, such as protection relays indicating the faulty line and the computer containing the network data system (not shown), are prior and applied art, and they are often installed for other reasons in any case. They do not belong to the invention, but form a possible application environment for the solution of the invention.
The current peaks related to an intermittent or transient earth fault can be utilised with the invention for detecting the fault and for determining its direction, i.e. the faulty line outlet F1. One way is to compare the polarities of the current peaks (or current pulse) with the sign of an instantaneous value of the voltage of the faulty phase L1 or with each other. The faulty phase L1 can be detected for instance by comparing the instantaneous values of phase currents with the effective values of the phase currents or with fundamental frequency components. When in some phase L1, L2 or L3 at a time instant the instantaneous value of the current divided by the effective value of the current in question exceeds a set limit, the current value in question will be interpreted as a peak value of the current. If in a phase L1, L2 or L3, the peak value of the current is higher than in other phases, the phase is considered to be faulty. Another way is to detect a faulty phase L1 from the size of the voltage. The voltage of a faulty phase L1 drops during an electric breakdown to a level considerably lower than normal, whereas the voltages of intact phases L2, L3 increase to a level higher than normal. Even then it is, however, preferable to detect a current peak and its time instant in the manner described above by comparing the instantaneous value with the effective value, for instance. Utilising the voltage of the faulty phase L1 is based on the fact that the polarity of the current peak related to an electric breakdown on a faulty line F1 is the same as the polarity of the instantaneous value of the voltage of the faulty phase L1 at the time of the electric breakdown. In the intact lines F2 and F3, the reference voltage in question is the same as in the faulty line F1, but the polarity of the current peak is the opposite; the current pulse running to the faulty point F in the faulty line F1 runs through the direct capacities to earth Ce21 to Ce33 of the intact lines F2 and F3. Another way is to compare current pulses with each other. The comparison can take place between different phases of one line or between different lines. The polarity of the current pulse, of a faulty phase L1 in a faulty line F1 is the opposite to the polarity of the current pulses of the intact phases L2 and L3. The current pulse of the faulty phase L1 is also higher than those of the intact phases L2 and L3. In a short line, the current pulses of the intact phases L2 and L3 may remain so low that they cannot be distinguished from the normal load current. The current pulse in the faulty phase L1 of the faulty line F1 is, however, usually higher than the normal load current. The protection can thus be based on the following criterion: if a higher current peak is detected in one phase, the line in question is faulty. The above methods for detecting a faulty phase and line outlet are only presented by way of example, and other methods can also be used in connection with the invention without this having relevance to the basic idea of the invention.

The marking lop shows the current pulse related to an intermittent or transient earth fault and running to earth at the faulty point F. The current pulse lop comes from the background network and is divided into the various branches of the ring line F1, S and F2 in proportion to their impedances. Let us mark the impedance ratio in question with p and define the following:

$$p = Z11/(Z11+Z12+Z21+Z22), \qquad (1)$$

wherein
Z11 = Z111, Z112 or Z113, wherein these are assumed to be equal, Z12 = Z121, Z122 or Z123, wherein these are assumed to be equal,
Z21 = Z211, Z212 or Z213, wherein these are assumed to be equal and
Z22 = Z221, Z222 or Z223, wherein these are assumed to be equal.
The value p indicates the location of the fault when the division of the impedance in the line is known. The value p can be calculated from the current pulses of the faulty phase measured from the different ends of the line loop F1, S and F2. Let us mark the amplitudes of the current pulses as Ir1 and Ir2, wherein Ir1 is measured at the joining point of the line outlet F1 and the busbar and Ir2 is measured at the joining point of the line outlet F2 and the busbar. It is assumed herein that the sampling frequency of the measurement equipment is high enough to allow the measurement of short-term current pulses. Then,

$$p = \frac{Ir2}{Ir1 + Ir2} \qquad (2)$$

applies.
The location of an intermittent or transient fault can thus be determined by measuring the currents of the faulty phase from the different ends of the ring line. Inaccuracy is caused in the calculation by the fact that the normal load current of the faulty phase L1 also affects the measured maximum value of the current. This inaccuracy cannot be eliminated by merely subtracting from the measured maximum value the instantaneous value of the phase current measured just before the pulse is created, since it is not a question of a superposition of two mutually independent current signals. Earth contact does immediately affect the instantaneous values of the load current, too. The accuracy of the pulse amplitude measurement is thus dependent on how high the load current is in relation to the current pulse caused by the fault.
The accuracy of determining the location of the fault can be increased by basing it on the pulses of the zero current, i.e. the pulses of the summation current of the phases. Then, it is, however, necessary to take into account the impact of the pulses running through the intact phases L2 and L3 of the ring line to the zero current pulse. The following applies to the amplitudes of the zero current pulses measured from the different ends of the ring line:

$$Io1 = Ir1 + Is1 + It1$$
$$Io2 = Ir2 + Is2 + It2$$

wherein

Lr1, Ls1 and It1 = the amplitudes of the current pulses of the phases measured from the joining point of the line outlet F1 and the busbar and

Ir2, Is2 and It2 = the amplitudes of the current pulses of the phases measured from the joining point of the line outlet F2 and the busbar.

From the sum clause of these, the fault current pulse lop can be obtained as follows:

$$Io1 + Io2 = (Ir1 + Ir2) + (Is1 + It1 + Is2 + It2) = Iop - \frac{2}{3} \times k \times Iop$$

$$\Leftrightarrow$$

$$Iop = \frac{Io1 + Io2}{1 - \frac{2}{3} \times k} \qquad (3)$$

Parameter k is the proportion of the direct capacity to earth of the ring line of the direct capacity to earth of the entire network:

$$k = \frac{Ce1 + Ce2}{Ce1 + Ce2 + Ce3}, \text{ wherein} \qquad (4)$$

wherein

Ce1 = Ce11, Ce12 or Ce13, wherein these are assumed to be equal,
Ce2 = Ce21, Ce22 or Ce23, wherein these are assumed to be equal,
Ce3 = Ce31, Ce32 or Ce33, wherein these are assumed to be equal (Ce3 thus depicts the direct capacity to earth per phase of the network external to the line loop).

The following applies to the current of the faulty phase of the loop end number 2:

$$Ir2 = p \times Iop$$

The following applies to the summed current pulse of the intact phases L2 and L3 of the line loop end 2 when taking in to account the opposite polarity of the current of the intact phases to the faulty phase L1:

$$Is2 + It2 = -\frac{2}{3} \times m \times k \times Iop, \qquad (5)$$

wherein m indicates the division of the current pulse of the intact phases between the different ends of the line. The coefficient (2/3) is included, because in the faulty line F1 only two of three phases feed opposing current pulses to the current pulses running to the faulty point F, whereas in the background network all three phases feed nearly same-sized current pulses having the same polarity. The pulses in different phases of the intact lines are same-sized and have the same polarity, since the momentary changes in phase voltages when a short-time earth contact is created are same-sized and the phase capacities to earth are nearly same-sized. With current pulses caused by a short-time earth contact, the situation thus differs from the fundamental component earth fault currents caused by a fixed earth contact, since during a fixed earth contact, the voltage to earth of the faulty phase is in the extreme case zero and there is nearly no earth fault current through the direct capacities to earth of a faulty phase of intact lines.

In general, it can be assumed that m is approximately 0.5, if the line constants calculated per a unit of length of both branches of the ring line are on an average approximately the same. A more accurate value can be calculated, if necessary, when the division of the longitudinal impedances and the direct capacities to earth of the line are known. This calculation can be done by a person skilled in the art by means of the general theory of electricity and it is not presented herein.

The following clause can now be written for the zero current pulse of the line loop end 2 to obtain value p:

$$Io2 = Ir2 + (Is2 + It2) = p \times Iop - \frac{2}{3} \times m \times k \times Iop \qquad (6)$$

$$\Leftrightarrow p = \frac{Io2 + \frac{2}{3} \times m \times k \times Iop}{Iop} = \frac{Io2}{Iop} + \frac{2}{3} \times m \times k \qquad (7)$$

$$\Rightarrow p = \frac{Io2}{Io1 + Io2} \times (1 - \frac{2}{3} \times k) + \frac{2}{3} \times m \times k \qquad (8)$$

Assuming that m = 0.5, the formula (8) can be altered to be:

$$\Rightarrow p = \frac{Io2}{Io1 + Io2} \times (1 - \frac{2}{3} \times k) + \frac{1}{3} \times k \qquad (9)$$

Using formulas (1), (2), (8) and (9), it is possible to calculate the location of the fault on a ring line by measuring the current pulses related to the same earth contact from both ends of the ring line. Applying the method into practice naturally requires that the impedances Z111 to Z223 of the ring line and their division on the length of the line are known. This way, the obtained value p can be changed into impedance data according to equation (10):

$$Z11 = p \times Ztot , \qquad (10)$$

wherein Ztot = Z11+Z12+Z21+Z22 is the total longitudinal impedance of the ring line calculated for the entire length of the line. When the average longitudinal impedance of the line is known per a unit of length, i.e. the value z, the distance of the fault F from the ring line end number 1 can be calculated, i.e. in Figure 2, from the joining point of the line outlet F1 and the busbar, as follows:

$$d = \frac{Z11}{z} , \qquad (11)$$

If the impedance of the line per a unit of length is not constant, but unequal at different points of the line, the distance estimate must be formed step by step by summing line sections having different impedances starting from the beginning of the faulty line outlet F1 and moving towards the faulty point F, until the calculated Z11 is full.

There are two alternative methods according to how the pulses are measured. One solution is to cable to the same apparatus (not shown) the current pulses from the current transformers or sensors (not shown) of both line ends. This solution provides the advantage that the synchronisation of measurements is easy. The drawback is that any of the lines F1, F2 and F3 can become faulty, in which case it must be possible to connect all line measurements to the same apparatus with the measurements of a second line. Said second line cannot, however, be fixedly selected, since any line may be temporarily completely inoperable. This solution thus requires that all measurements of lines in an electric station be connected to the same apparatus.

Another solution is to cable the signals of each measurement transformer or sensor to one line-specific apparatus only and to transmit the measurement data preferably in digital format on to the central apparatus so that the measurements of the different ends can be compared. This solution requires that the measurements be synchronised with each other so that it is possible to know that the measurements compared with each other are related to the same time instants. For such synchronisation, there are, however, known technical solutions which do not belong to the subject matter of the invention. This type of decentralised solution provides the advantage that it is more easy to expand, because no fixed cabling is needed for a given number of lines. This type of solution can be easily expanded and applied to electric stations of different sizes.

Various modifications also exist depending on whether a new estimate d for the location of the fault is calculated separately for each occurring earth contact and the ensuing current pulse, or whether the average of several current pulse amplitudes is first calculated from the measurements at both ends and the location is based on the averages.

The alternative based on zero current pulse amplitudes is more advantageous than the implementation based on phase currents, since this way the normal load current does not affect the measurements by adding to their inaccuracy. The most preferable method is to use the average of various current pulses, in which case less measurement data need to be transmitted from the line-specific apparatuses to the central apparatus. Even though the size of the current pulses varies somewhat according to the creation time of the earth contact and the fault resistance, the variation occurs in the same proportion at both ends of the ring line. Therefore, performing the comparison on each pulse separately does not provide any additional information, especially since only one value must finally be formed of the various distance estimates. It is, however, preferable that the line-specfic apparatuses calculate the averages of current pulse amplitudes for a certain pre-set number of earth contacts. This provides an advantage when the amplitude varies considerably. This averts the danger of having one apparatus include in the average a considerably higher or lower value than the others while a second apparatus leaves said value out of the average.

It is assumed herein that the apparatuses applying the invention have means to detect current pulses. This may be based on any known technology, such as comparing a maximum value with an effective value or a fundamental frequency component, without having any relevance to the basic idea of the invention.

It is obvious to a person skilled in the art that as technology advances, the basic idea of the invention can be implemented in many different ways. The invention and its embodiments are thus not limited to the examples described above but may vary within the scope of the claims.

## Claims

1.  A method of locating intermittent and transient earth faults in an electric network which comprises one or more line outlets going out from a feeding point, the impedances per unit of length of the lines in the electric network being known, and which network has at least two phases, the method comprising steps of

    detecting an earth contact related to an intermittent or transient earth fault in the electric network,
    detecting a faulty line outlet in which the earth contact occurs, and
    connecting at least a part of the electric network in a loop in such a manner that a part of the loop is made up of the faulty line outlet and the loop is fed from the ends of the loop, **characterized by**
    measuring the amplitudes of current pulses related to at least one ensuing earth contact, or other quantities proportional to them, at the ends of the loop comprising the faulty line outlet, and
    determining the location of the earth contact point by means of the measured quantities and the impedance data of the line section of the electric network connected in a loop.

2.  A method as claimed in claim 1, **characterized in that** the step for measuring the current pulses is performed to a certain pre-set number of ensuing earth contacts, whereby an average of the values of each quantity measured during various earth contacts is used in determining the location of the earth contact point.

3. A method as claimed in claim 1 or 2, **characterized in that** the step for measuring the current pulses comprises steps of

detecting a faulty phase, and
measuring the amplitudes of the current pulses of the faulty phase at the ends of the loop comprising the faulty line outlet.

4. A method as claimed in claim 3, **characterized in that** the location of the earth contact point is determined by means of formula:

$$d = \frac{\dfrac{Ir2}{Ir1 + Ir2} \times Ztot}{z},$$

wherein

d = the distance of the earth contact point from the first end of the loop,
Ir1 = the amplitude of the current pulse of the faulty phase at the first end of the loop,
Ir2 = the amplitude of the current pulse of the faulty phase at the second end of the loop,
Ztot = the total longitudinal impedance of the loop, and
z = the longitudinal impedance of the loop per unit of length.

5. A method as claimed in claim 1 or 2, **characterized in that** the step for measuring the current pulses comprises a step of
measuring the amplitude of the pulse occurring in the summation current of the phases at both ends of the loop comprising the faulty line outlet.

6. A method as claimed in claim 5, **characterized in that** the location of the earth contact point is determined using formula:

$$d = \frac{[\dfrac{Io2}{Io1 + Io2} \times (1 - \dfrac{2}{3} \times k) + \dfrac{2}{3} \times m \times k] \times Ztot}{z},$$

wherein

d = the distance of the earth contact point from the first end of the loop,
Io1 = the amplitude of the summation current pulse of the phases at the first end of the loop,
Io2 = the amplitude of the summation current pulse of the phases at the second end of the loop,
k = Cs/Ctot, wherein Cs = is the direct capacity to earth of the loop and Ctot = the total direct capacity to earth of the network,
m = the coefficient depicting the division of the current pulse of intact phases between the ends of the loop,
Ztot = the total longitudinal impedance of the loop, and
z = the longitudinal impedance of the loop per unit of length.

7. A system for locating intermittent and transient earth faults in an electric network which comprises one or more line outlets (F1, F2, F3) going out from a feeding point, the impedances (Z111 to Z223, Ce11 to Ce33) per unit of length of the lines in the electric network being known, and which network has at least two phases (L1, L2, L3), the system being arranged to
detect an earth contact related to an intermittent or transient earth fault (F) in the electric network,
detect a faulty line outlet (F1) in which the earth contact occurs, and
connect at least a part of the electric network in a loop (F1, S, F2) in such a manner that at least a part of the loop is made up of the faulty line outlet (F1) and the loop is fed from the ends of the loop, **characterized in that** the system is also arranged to
measure the amplitudes of current pulses related to at least one ensuing earth contact, or other quantities proportional to them, at the ends of the loop comprising the faulty line outlet (F1), and
determine the location of the earth contact point (F) by means of the measured quantities and the impedance data of the line section of the electric network connected in a loop.

8. A system as claimed in claim 7, **characterized in that** the system is arranged to measure the current pulses of a certain pre-set number of ensuing earth contacts and to use the average of the values of each quantity measured during various earth contacts in determining the location of the earth contact point.

9. A system as claimed in claim 7 or 8, **characterized in that** the system is arranged, when measuring the current pulses, to
detect a faulty phase (L1), and
to measure the amplitudes of the current pulses of the faulty phase at the ends of the loop (F1, S, F2) comprising the faulty line outlet (F1).

10. A system as claimed in claim 9, **characterized in that** the system is arranged to determine the location of the earth contact point (F) using formula:

$$d = \frac{\dfrac{Ir2}{Ir1 + Ir2} \times Ztot}{z},$$

wherein

d = the distance of the earth contact point from the first end of the loop,
Ir1 = the amplitude of the current pulse of the faulty phase at the first end of the loop,
Ir2 = the amplitude of the current pulse of the faulty phase at the second end of the loop,
Ztot = the total longitudinal impedance of the loop, and
z = the longitudinal impedance of the loop per unit of length.

11. A system as claimed in claim 7 or 8, **characterized in that** the system is arranged, when measuring the current pulses, to
measure the amplitude of the pulse occurring in the summation current of the phases (L1, L2, L3) at each end of the loop (F1, S, F2) comprising the faulty line outlet (F1).

12. A system as claimed in claim 11, **characterized in that** the system is arranged to determine the location of the earth contact point (F) using formula:

$$d = \frac{[\dfrac{Io2}{Io1 + Io2} \times (1 - \dfrac{2}{3} \times k) + \dfrac{2}{3} \times m \times k] \times Ztot}{z},$$

wherein

d = the distance of the earth contact point from the first end of the loop,
Io1 = the amplitude of the summation current pulse of the phases at the first end of the loop,
Io2 = the amplitude of the summation current pulse of the phases at the second end of the loop,
k = Cs/Ctot, wherein Cs = is the direct capacity to earth of the loop and Ctot = the total direct capacity to earth of the network,
m = the coefficient depicting the division of the current pulse of intact phases between the ends of the loop,
Ztot = the total longitudinal impedance of the loop, and

z = the longitudinal impedance of the loop per unit of length.

**Patentansprüche**

1.  Verfahren zur Lokalisierung von intermittierenden und transienten Erdschlüssen in einem elektrischen Netz, das einen oder mehr von einem Speisepunkt ausgehende Leitungsausgänge aufweist, wobei die Impedanzen pro Längeneinheit der Leitungen im elektrischen Netz bekannt sind, welches Netz mindestens zwei Phasen aufweist, wobei das Verfahren die folgenden Schritte aufweist:

    Detektieren eines mit einem intermittierenden oder transienten Erdschluss zusammenhängenden Erdkontakts im elektrischen Netz,
    Detektieren eines defekten Leitungsausgangs, in dem der Erdkontakt stattfindet, und
    Schalten mindestens eines Teils des elektrischen Netzes zu einer Schleife, so dass ein Teil der Schleife aus dem defekten Leitungsausgang besteht und die Schleife von den Enden der Schleife gespeist wird, **gekennzeichnet durch**
    Messen der Amplituden von mindestens einem folgenden Erdkontakt zugehörigen Stromimpulsen oder anderer zu diesen proportionaler Größen an den Enden der den defekten Leitungsausgang aufweisenden Schleife und
    Bestimmen der Lage des Erdkontaktpunkts anhand der gemessenen Größen und der Impedanzdaten des zu einer Schleife geschalteten Leitungsabschnitts des elektrischen Netzes.

2.  Verfahren nach Anspruch 1, **dadurch gekennzeichnet, dass** der Schritt, in dem die Stromimpulse gemessen werden, für eine gewisse vorgegebene Anzahl von folgenden Erdkontakten ausgeführt wird, wobei ein Durchschnittswert der während verschiedener Erdkontakte gemessenen Werte jeder Größe zur Bestimmung der Lage des Erdkontaktpunktes eingesetzt wird.

3.  Verfahren nach Anspruch 1 oder 2, **dadurch gekennzeichnet, dass** der Schritt, in dem die Stromimpulse gemessen werden, die folgenden Schritte aufweist:

    Detektieren einer defekten Phase und
    Messen der Amplituden der Stromimpulse der defekten Phase an den Enden der den defekten Leitungsausgang aufweisenden Schleife.

4.  Verfahren nach Anspruch 3, **dadurch gekennzeichnet, dass** die Lage des Erdkontaktpunkts durch die folgende Formel bestimmt wird:

$$d = \frac{\dfrac{Ir2}{Ir1 + Ir2} \times Ztot}{z},$$

    worin

    d = der Abstand zwischen dem Erdkontaktpunkt und dem ersten Ende der Schleife,
    Ir1 = die Amplitude des Stromimpulses der defekten Phase am ersten Ende der Schleife,
    Ir2 = die Amplitude des Stromimpulses der defekten Phase am zweiten Ende der Schleife,
    Ztot = die gesamte Längsimpedanz der Schleife und
    z = die Längsimpedanz der Schleife pro Längeneinheit.

5.  Verfahren nach Anspruch 1 oder 2, **dadurch gekennzeichnet, dass** der Schritt, in dem die Stromimpulse gemessen werden, einen folgenden Schritt aufweist:

    Messen der Amplitude des im Summenstrom der Phasen vorkommenden Impulses an beiden Enden der den defekten Leitungsausgang aufweisenden Schleife.

6.  Verfahren nach Anspruch 5, **dadurch gekennzeichnet, dass** die Lage des Erdkontaktpunkts durch die folgende Formel bestimmt wird:

$$d = \frac{\left[\dfrac{Io2}{Io1 + Io2} \times \left(1 - \dfrac{2}{3} \times k\right) + \dfrac{2}{3} \times m \times k\right] \times Ztot}{z},$$

worin

d = der Abstand zwischen dem Erdkontaktpunkt und dem ersten Ende der Schleife,
Io1 = die Amplitude des Summenstromimpulses der Phasen am ersten Ende der Schleife,
Io2 = die Amplitude des Summenstromimpulses der Phasen am zweiten Ende der Schleife,
k = Cs/Ctot, worin Cs = die direkte Erdkapazität der Schleife und Ctot = die gesamte direkte Erdkapazität des Netzes,
m = der Koeffizient, der die Aufteilung des Stromimpulses von intakten Phasen zwischen den Enden der Schleife bezeichnet,
Ztot = die gesamte Längsimpedanz der Schleife und
z = die Längsimpedanz der Schleife pro Längeneinheit.

7. System zur Lokalisierung von intermittierenden und transienten Erdschlüssen in einem elektrischen Netz, das einen oder mehr von einem Speisepunkt ausgehende Leitungsausgänge (F1, F2, F3) aufweist, wobei die Impedanzen (Z111 bis Z223, Ce11 bis Ce33) pro Längeneinheit der Leitungen im elektrischen Netz bekannt sind, welches Netz mindestens zwei Phasen (L1, L2, L3) aufweist, wobei das System angeordnet ist,
einen mit einem intermittierenden oder transienten Erdschluss (F) zusammenhängenden Erdkontakt im elektrischen Netz zu detektieren,
einen defekten Leitungsausgang (F1) zu detektieren, in dem der Erdkontakt stattfindet, und
mindestens einen Teil des elektrischen Netzes zu einer Schleife (F1, S, F2) zu schalten, so dass ein Teil der Schleife aus dem defekten Leitungsausgang (F1) besteht und die Schleife von den Enden der Schleife gespeist wird, **dadurch gekennzeichnet, dass** das System auch angeordnet ist,
die Amplituden von mindestens einem folgenden Erdkontakt zugehörigen Stromimpulsen oder andere zu diesen proportionale Größen an den Enden der den defekten Leitungsausgang (F1) aufweisenden Schleife zu messen und die Lage des Erdkontaktpunkts (F) anhand der gemessenen Größen und der Impedanzdaten des zu einer Schleife geschalteten Leitungsabschnitts des elektrischen Netzes zu bestimmen.

8. System nach Anspruch 7, **dadurch gekennzeichnet, dass** das System angeordnet ist, die Stromimpulse einer gewissen vorgegebenen Anzahl von folgenden Erdkontakten zu messen und den Durchschnittswert der während verschiedener Erdkontakte gemessenen Werte jeder Größe zur Bestimmung der Lage des Erdkontaktpunktes einzusetzen.

9. System nach Anspruch 7 oder 8, **dadurch gekennzeichnet, dass** das System bei Messung der Stromimpulse angeordnet ist,
eine defekte Phase (L1) zu detektieren und
die Amplituden der Stromimpulse der defekten Phase an den Enden der den defekten Leitungsausgang (F1) aufweisenden Schleife (F1, S. F2) zu messen.

10. System nach Anspruch 9, **dadurch gekennzeichnet, dass** das System angeordnet ist, die Lage des Erdkontaktpunkts (F) durch die folgende Formel zu bestimmen:

$$d = \frac{\dfrac{Ir2}{Ir1 + Ir2} \times Ztot}{z},$$

worin

d = der Abstand zwischen dem Erdkontaktpunkt und dem ersten Ende der Schleife,
Ir1 = die Amplitude des Stromimpulses der defekten Phase am ersten Ende der Schleife,
Ir2 = die Amplitude des Stromimpulses der defekten Phase am zweiten Ende der Schleife,
Ztot = die gesamte Längsimpedanz der Schleife und
z = die Längsimpedanz der Schleife pro Längeneinheit.

11. System nach Anspruch 7 oder 8, **dadurch gekennzeichnet, dass** das System bei Messung der Stromimpulse angeordnet ist,
die Amplitude des im Summenstrom der Phasen (L1, L2, L3) vorkommenden Impulses an jedem Ende der den defekten Leitungsausgang (F1) aufweisenden Schleife (F1, S, F2) zu messen.

12. System nach Anspruch 11, **dadurch gekennzeichnet, dass** das System angeordnet ist, die Lage des Erdkontaktpunkts (F) durch die folgende Formel zu bestimmen:

$$d = \frac{[\frac{Io2}{Io1 + Io2} \times (1 - \frac{2}{3} \times k) + \frac{2}{3} \times m \times k] \times Ztot}{z},$$

worin

d = der Abstand zwischen dem Erdkontaktpunkt und dem ersten Ende der Schleife,
Io1 = die Amplitude des Summenstromimpulses der Phasen am ersten Ende der Schleife,
Io2 = die Amplitude des Summenstromimpulses der Phasen am zweiten Ende der Schleife,
k = Cs/Ctot, worin Cs = die direkte Erdkapazität der Schleife und Ctot = die gesamte direkte Erdkapazität des Netzes,
m = der Koeffizient, der die Aufteilung des Stromimpulses von intakten Phasen zwischen den Enden der Schleife bezeichnet,
Ztot = die gesamte Längsimpedanz der Schleife und
z = die Längsimpedanz der Schleife pro Längeneinheit.

## Revendications

1. Procédé de localisation de défauts de terre transitoires et intermittents dans un réseau électrique qui comprend une ou plusieurs sorties de ligne sortant d'un point d'alimentation, les impédances par unité de longueur des lignes du réseau électrique étant connues, et lequel réseau présente au moins deux phases, le procédé comprenant les étapes ci-dessous consistant à :

   détecter un contact de terre relatif à un défaut de terre transitoire et intermittent dans le réseau électrique ;
   détecter une sortie de ligne défaillante dans laquelle le contact de terre se produit ; et
   connecter au moins une partie du réseau électrique en boucle d'une manière telle qu'une partie de la boucle est constituée de la sortie de ligne défaillante et que la boucle est alimentée à partir des extrémités de la boucle, **caractérisé par** les étapes ci-dessous consistant à :

      mesurer les amplitudes d'impulsions de courant relatives à au moins un contact de terre résultant, ou d'autres quantités proportionnelles à ces amplitudes, au niveau des extrémités de la boucle comprenant la sortie de ligne défaillante ; et
      déterminer l'emplacement du point de contact de terre par le biais des quantités mesurées et des données d'impédance de la partie de ligne du réseau électrique connecté en boucle.

2. Procédé selon la revendication 1, **caractérisé en ce que** l'étape consistant à mesurer les impulsions de courant est mise en oeuvre sur un certain nombre prédéfini de contacts de terre résultants, moyennant quoi une moyenne des valeurs de chaque quantité mesurée au cours de multiples contacts de terre est utilisée pour déterminer l'emplacement du point de contact de terre.

**3.** Procédé selon la revendication 1 ou 2, **caractérisé en ce que** l'étape consistant à mesurer les impulsions de courant comporte les étapes ci-dessous consistant à :

détecter une phase défaillante ; et
mesurer l'amplitude des impulsions de courant de la phase défaillante aux extrémités de la boucle comprenant la sortie de ligne défaillante.

**4.** Procédé selon la revendication 3, **caractérisé en ce que** l'emplacement du point de contact de terre est déterminé au moyen de la formule ci-dessous :

$$d = \frac{\frac{Ir2}{Ir1 + Ir2} * Ztot}{z},$$

où

d = la distance du point de contact de terre depuis la première extrémité de la boucle ;
Ir1 = l'amplitude de l'impulsion de courant de la phase défaillante à la première extrémité de la boucle ;
Ir2 = l'amplitude de l'impulsion de courant de la phase défaillante à la deuxième extrémité de la boucle ;
Ztot = l'impédance longitudinale totale de la boucle ; et
z = l'impédance longitudinale de la boucle par unité de longueur.

**5.** Procédé selon la revendication 1 ou 2, **caractérisé en ce que** l'étape consistant à mesurer les impulsions de courant comprend une étape consistant à :

mesurer l'amplitude de l'impulsion occasionnée dans le courant sommateur des phases aux deux extrémités de la boucle comprenant la sortie de ligne défaillante.

**6.** Procédé selon la revendication 5, **caractérisé en ce que** l'emplacement du point de contact de terre est déterminé selon la formule :

$$d = \frac{\left[ \frac{Io2}{Io1 + Io2} * (1 - \frac{2}{3} * k) + \frac{2}{3} * m * k \right] * Ztot}{z},$$

où

d = la distance du point de contact de terre depuis la première extrémité de la boucle ;
Io1 = l'amplitude des impulsions de courant sommateur des phases à la première extrémité de la boucle ;
Io2 = l'amplitude des impulsions de courant sommateur des phases à la seconde extrémité de la boucle ;
k = Cs / Ctot, où C = est la capacité directe à la terre de la boucle et Ctot = la capacité directe totale à la terre du réseau ;
m = le coefficient représentant la division de l'impulsion de courant de phases intactes entre les extrémités de la boucle ;
Ztot = l'impédance longitudinale totale de la boucle ; et
z = l'impédance longitudinale de la boucle par unité de longueur.

**7.** Système de localisation de défauts de terre transitoires et intermittents dans un réseau électrique qui comprend une ou plusieurs sorties de ligne (F1, F2, F3) sortant d'un point d'alimentation, les impédances (Z111 à Z223, Ce11 à Ce33) par unité de longueur des lignes du réseau électrique étant connues, et lequel réseau présente au moins deux phases (L, L2, L3), le système étant agencé de manière à :

détecter un contact de terre relatif à un défaut de terre transitoire et intermittent (F) dans le réseau électrique ;

détecter une sortie de ligne défaillante (F1) dans laquelle le contact de terre se produit ; et

connecter au moins une partie du réseau électrique en boucle (F1, S, F2) d'une manière telle qu'au moins une partie de la boucle est constituée de la sortie de ligne défaillante (F1) et que la boucle est alimentée à partir des extrémités de la boucle, **caractérisé en ce que** le système est en outre agencé de manière à :

mesurer les amplitudes d'impulsions de courant relatives à au moins un contact de terre résultant, ou d'autres quantités proportionnelles à ces amplitudes, au niveau des extrémités de la boucle comprenant la sortie de ligne défaillante (F1) ; et

déterminer l'emplacement du point de contact de terre (F) par le biais des quantités mesurées et des données d'impédance de la partie de ligne du réseau électrique connecté en boucle.

8. Système selon la revendication 7, **caractérisé en ce que** le système est agencé de manière à mesurer les impulsions de courant d'un certain nombre prédéfini de contacts de terre résultants et à utiliser la moyenne des valeurs de chaque quantité mesurée au cours de multiples contacts de terre pour déterminer l'emplacement du point de contact de terre.

9. Système selon la revendication 7 ou 8, **caractérisé en ce que** le système est agencé, lors de la mesure des impulsions de courant, de manière à :

détecter une phase défaillante (L1) ; et

mesurer les amplitudes des impulsions de courant de la phase défaillante aux extrémités de la boucle (F1, S, F2) comprenant la sortie de ligne défaillante (F1).

10. Système selon la revendication 9, **caractérisé en ce que** le système est agencé de manière à déterminer l'emplacement du point de contact de terre (F) selon la formule :

$$d = \frac{\dfrac{Ir2}{Ir1 + Ir2} * Ztot}{z} \; ,$$

où

d = la distance du point de contact de terre depuis la première extrémité de la boucle ;
Ir1 = l'amplitude de l'impulsion de courant de la phase défaillante à la première extrémité de la boucle ;
Ir2 = l'amplitude de l'impulsion de courant de la phase défaillante à la deuxième extrémité de la boucle ;
Ztot = l'impédance longitudinale totale de la boucle ; et
z = l'impédance longitudinale de la boucle par unité de longueur.

11. Système selon la revendication 7 ou 8, **caractérisé en ce que** le système est agencé, lors de la mesure des impulsions de courant, de manière à :

mesurer l'amplitude de l'impulsion rencontrée dans le courant sommateur des phases (L1, L2, L3) à chaque extrémité de la boucle (F1, S, F2) comprenant la sortie de ligne défaillante (F1).

12. Système selon la revendication 11, **caractérisé en ce que** le système est agencé de manière à déterminer l'emplacement du point de contact de terre (F) selon la formule :

$$d = \frac{\left[\dfrac{Io2}{Io1 + Io2} * (1 - \dfrac{2}{3} * k) + \dfrac{2}{3} * m * k\right] * Ztot}{z} \; ,$$

où

d = la distance du point de contact de terre depuis la première extrémité de la boucle ;

Io1 = l'amplitude des impulsions de courant sommateur des phases à la première extrémité de la boucle ;
Io2 = l'amplitude des impulsions de courant sommateur des phases à la seconde extrémité de la boucle ;
k = Cs / Ctot, où C = est la capacité directe à la terre de la boucle et Ctot = la capacité directe totale à la terre du réseau ;
m = le coefficient représentant la division de l'impulsion de courant de phases intactes entre les extrémités de la boucle ;
Ztot = l'impédance longitudinale totale de la boucle ; et
z = l'impédance longitudinale de la boucle par unité de longueur.

Io1 = l'amplitude des impulsions de courant sommateur des phases à la première extrémité de la boucle ;
Io2 = l'amplitude des impulsions de courant sommateur des phases à la seconde extrémité de la boucle ;
k = Cs / Ctot, où C = est la capacité directe à la terre de la boucle et Ctot = la capacité directe totale à la terre

Fig. 1

AMPLITUDE

TIME

Fig. 2

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- DE 3344208

- US 5839093 A